# EUROPEAN PATENT SPECIFICATION

(11) **EP 4 503 425 B1**
(45) Date of publication and mention of the grant of the patent: **04.11.2026**
(21) Application number: 23893381.6
(22) Date of filing: 15.09.2023
(51) Int. Cl.: H02N 11/00, G05D 23/20, H02J 50/00, H02J 50/10, H02J 7/32, H02J 7/00, H05K 7/20, H02J 7/65, H02J 7/70

(54) **CONTROLLABLE-TEMPERATURE HUMAN BODY CHARGING APPARATUS**
AUFLADEVORRICHTUNG FÜR MENSCHLICHEN KÖRPER MIT STEUERBARER TEMPERATUR
APPAREIL DE CHARGE DE CORPS HUMAIN À TEMPÉRATURE RÉGLABLE

(30) Priority: 24.11.2022 CN 202211483068
(43) Date of publication of application: 05.02.2025
(73) Proprietor: Zhuhai CosMX Battery Co., Ltd., Zhuhai, Guangdong 519180 (CN)
(72) Inventor: LI, Suli, Zhuhai, Guangdong 519180 (CN); ZHAO, Wei, Zhuhai, Guangdong 519180 (CN); DONG, Derui, Zhuhai, Guangdong 519180 (CN)
(74) Representative: Elzaburu S.L.P.
(86) International application number: PCT/CN2023/119252
(87) International publication number: WO 2024/109288

(56) References cited:
- CN-A- 104 395 719
- CN-A- 105 916 363
- CN-A- 106 237 516
- CN-A- 115 733 390
- CN-U- 208 492 985
- CN-U- 212 851 276
- CN-U- 212 851 276
- DE-U1- 202018 103 685
- TW-A- 201 231 811
- US-A1- 2009 082 832
- US-A1- 2009 082 832
- US-A1- 2010 256 708
- US-A1- 2010 256 708
- US-B1- 6 586 912
- US-B2- 10 322 288

## Description

The present application claims priority to Chinese Patent Application No. 202211483068.0 filed with China National Intellectual Property Administration on November 24, 2022 and entitled "temperature-controllable human body charging apparatus", which is hereby incorporated by reference in its entirety.

### TECHNICAL FIELD

The present application relates to a charging apparatus, in particular to a temperature-controllable human body charging apparatus, and belongs to the technical field of medical devices.

### BACKGROUND

Since the application of the first implantable cardiac pacemaker in 1960, a wide variety of battery-powered active implantable medical devices have been widely used for detection and treatment of various diseases, such as implantable cardiac pacemakers and defibrillators, various nerve stimulators (including brain pacemakers, spinal cord stimulators, vagus nerve stimulators, sacral nerve stimulators, phrenic nerve stimulators, etc.), drug pumps, electrocardiocorder, etc.

At present, most of the batteries used in active implantable medical devices are disposable lithium batteries. Disposable lithium batteries have a very high specific energy density, which can reach 1000-1300Wh/L. However, despite the high specific energy, the service life of the disposable batteries is only about 7-10 years, and regular surgery to replace batteries is required, which brings great pain to patients. Secondary rechargeable batteries can solve this problem well.

Wireless charging using the principle of high-frequency alternating electromagnetic field is a preferred charging method for the secondary rechargeable batteries. However, the eddy current and heat generation effect produced by high-frequency alternating electromagnetic field in metal conductor will make patients face the risk of internal tissue and organ being burned to varying degrees, and thus it is still impossible for patients to completely eliminate the negative psychological and physiological effects brought by active implantable medical devices.

US20090082832A1 discloses a thermal management of implantable medical devices. Systems and techniques for thermal management of implantable medical devices. In one aspect, an implantable device adapted for implantation in a body includes a conductor component that conducts an electrical current in response to the body in which that implantable device is implanted being subjected to an alternating electromagnetic field and a thermal management component in thermal contact with the conductor component and configured to manage excess heat generated by the conduction of the electrical current. The thermal management component comprises a material that undergoes a phase transition at a temperature above the temperature of the body in which the implantable device is adapted to be implanted.

US2010256708A1 discloses an implantable device with heat storage. Example embodiments of an implantable device are configured to be implanted within a patient to provide medical therapy to the patient. In general, an implantable rechargeable device includes a rechargeable battery and an electronic board assembly arranged within a case and an antenna electrically coupled to the rechargeable battery. The antenna is configured to receive power and to transfer at least a portion of the received power to the rechargeable battery for recharging. A phase change material is arranged within the case around at least a portion of the electronic board assembly. The phase change material is configured to transition from a first phase to a second phase at a transition temperature when the insulating material absorbs heat (e.g., from the electronic board assembly).

CN212851276U discloses a charger housing, charger and electronic device set. The invention provides a charger shell, a charger and an electronic device kit, the charger shell comprises an inner shell and an outer shell, and the inner shell and the outer shell are spaced by a set distance to form a cavity. A phase-change heat storage layer is arranged in the cavity and is made of a phase-change material, or a charger shell is a phase-change heat storage shell which is made of a phase-change material. The charger shell can absorb heat, and after the temperature around the phase change heat storage layer is reduced, the heat is gradually released. When the charger works at high power, an internal electronic device can emit a large amount of heat in a short time, and the phase change heat storage layer is used for absorbing the heat, so that the temperature rising speed of the charger shell can be reduced, and the temperature of the charger shell can be reduced.

### SUMMARY

The present application provides a temperature-controllable human body charging apparatus, and the charging apparatus can effectively reduce or inhibit the risk of burning organ and tissue in the human body caused by the temperature rise phenomenon of the charging apparatus. The present application is set out in the appended set of claims.

The present application provides a temperature-controllable human body charging apparatus, which includes a thermally conductive temperature control unit and a charging unit, where the temperature control unit includes a phase change material, and the temperature control unit is configured to absorb heat released by the charging unit.

The temperature-controllable human body charging apparatus provided by the present application realizes the absorption of heat from the charging unit by the temperature control unit through configuring the temperature control unit including the phase change material, so that the temperature in the patient's body near the charging apparatus is controlled, avoiding the phenomenon that some organs and tissues are burned due to excessively high temperature.

Further, because the temperature control unit overcomes the eddy current and heat generation effect of the charging apparatus, the charging unit has higher tolerance for the related parameters of wireless charging, so that the temperature-controllable human body charging apparatus can also reduce the cost of the wireless charging apparatus and broaden the application range of the wireless charging apparatus.

The invention is defined by the appended claims.

### BRIEF DESCRIPTION OF DRAWINGS

FIG. 1 is a sectional structural schematic diagram of a temperature-controllable human body charging apparatus according to an embodiment of the present application.
FIG. 2 is a structural schematic diagram of a temperature difference power generation unit of a temperature-controllable human body charging apparatus according to an embodiment of the present application.
FIG. 3 is a sectional structural schematic diagram of a temperature-controllable human body charging apparatus according to an embodiment of the present application.

### DESCRIPTION OF EMBODIMENTS

To make the object, technical solution and advantages of the present application more clear, the following will describe the technical solutions in embodiments of the present application clearly and completely with reference to the embodiments of the present application.

The present application provides a temperature-controllable human body charging apparatus, which includes a thermally conductive temperature control unit and a charging unit, where the temperature control unit includes a phase change material, and the temperature control unit is configured to absorb heat released by the charging unit.

The charging unit is an in-vivo charger commonly provided for active implantable medical devices in the art. Exemplarily, the charging unit includes a wireless receiving coil, a rectifier, an energy accumulator and a controller, which are electrically connected in sequence. Where, the wireless receiving coil is used to cooperate with a wireless transmitting coil outside the body to generate electric energy using the principle of high-frequency alternating electromagnetic field, and the generated electric energy is converted by the rectifier and then enters the energy accumulator for energy storage. Finally, when the power of the active implantable medical device is insufficient, the controller controls the energy accumulator to realize the release and adjustment of the electric energy therein and to charge the active implantable medical device. Further, the controller also has a temperature monitoring function and a turn-off function. When the temperature of the charging unit is monitored to be higher than an alarm temperature (for example, 41°C), the controller may cut off the mutual cooperation between the wireless receiving coil and the wireless transmitting coil to stop charging.

When the wireless receiving coil is used to cooperate with the wireless transmitting coil outside the body to generate electric energy using the principle of high-frequency alternating electromagnetic field, eddy current effect and exothermic effect may occur in the charging unit. The temperature control unit in the present application is used to absorb the heat released by the charging unit during the charging process, thereby avoiding the human organ and tissue near the charging unit from being burned by the heat generated by the charging unit as well as further human discomfort.

Specifically, the temperature control unit in the present application includes a phase change material, which can absorb heat generated from the outside and raise the temperature. When the temperature reaches a phase change point thereof, the phase change material undergoes a phase transformation on the premise of maintaining its own temperature without changing, thus functioning in heat absorption and storage. Compared with an in-vivo charging apparatus including no temperature control unit, the temperature control unit of the charging apparatus in the present application may absorb and store the heat released during a charging process of the charging unit, avoiding the damage to human caused by this part of heat conductive to human organ and tissue.

After the charging unit is finished charging, the charging unit no longer generates heat and the entire charging apparatus is at a normal body temperature. At this time, the heat stored in the phase change material may be slowly released and does not cause any discomfort to the human body.

Taking an original phase change material as the solid phase (as solid phase at and below normal body temperature) as an example, when the charging unit is working normally, the heat generated by the charging unit may be absorbed by the temperature control unit including the phase change material. With the continuous absorption of the heat, when the temperature of the phase change material rises to a phase transition point thereof, the phase change material may gradually transform from the solid phase to a liquid phase, and the heat absorbed by the phase change material may be stored in the phase change material as the liquid phase. After the charging is finished, temperatures of the charging unit and its surroundings are consistent with the body temperature. At this time, the phase change material as the liquid phase will slowly release the heat and transform into a solid phase, and then continue to be used to achieve heat absorption during the next charging process.

Therefore, the temperature control unit in the temperature-controllable human body charging apparatus of the present application is equivalent to a thermostat, and can ensure that the organ and tissue around the charging apparatus are in a normal temperature range, reducing or avoiding the negative impact of the in-vivo charging apparatus on the human body.

Further, since the temperature-controllable human body charging apparatus of the present application overcomes the defects of the in-vivo charging apparatus to a certain extent, the charging apparatus has higher tolerance for related charging parameters including wireless charging distance, charging frequency and charging efficiency during the charging process, and may realize the charging of the charging apparatus with longer distance, higher frequency and higher efficiency, reduce the research and development cost of the in-vivo charging apparatus, and realize the wider range of popularization and application of the in-vivo charging apparatus.

The present application does not limit the specific selection of the phase change material, and any material which can absorb heat and undergo phase change without further temperature change on its own after phase change can be used as the phase change material in the present application.

The present application does not limit specific locations of or connection relationship between the charging unit and the temperature control unit, as long as the temperature control unit can absorb the heat of the charging unit. For example, the charging unit and the temperature control unit may not have any connection relationship, such as, they can realize the heat transfer through an inert gas as a thermal conduction medium, or they can be connected through a tangible thermal conductor to realize the heat transfer.

In order to enable the temperature control unit to absorb the heat released by the charging unit to a maximum extent, the structures of and relative position relationship between the temperature control unit and the charging unit can be further limited.

In the current invention, the temperature control unit includes a housing with an accommodating cavity, the charging unit is located in the accommodating cavity, and the housing wraps the charging unit. At this time, since the charging unit is completely wrapped by the temperature control unit, the heat released by the charging unit may be almost completely absorbed by the temperature control unit, and thus the heat is prevented from being transferred to human organ and tissue due to incomplete heat absorption by the temperature control unit.

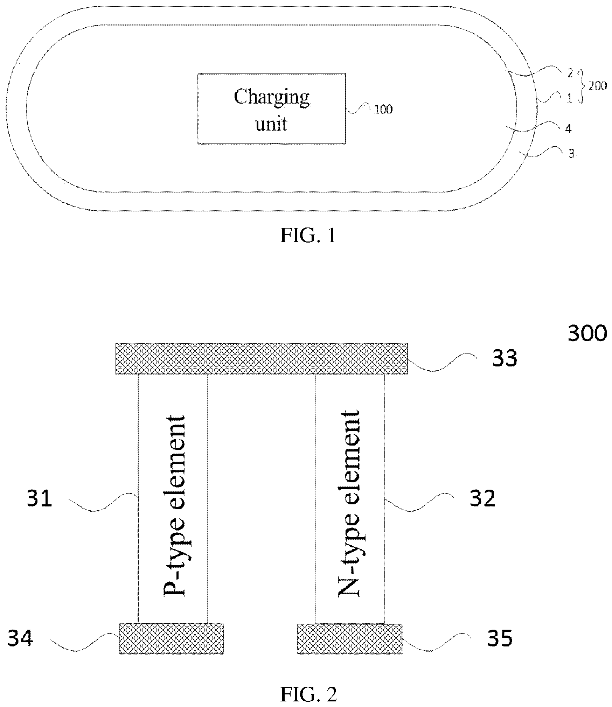

FIG. 1 is a sectional structural schematic diagram of a temperature-controllable human body charging apparatus according to the present application. As shown in FIG. 1, a housing 200 includes a first housing 1 and a second housing 2, where the first housing 1 is enclosed outside the second housing 2 and forms an enclosed cavity 3 with the first housing 1; the second housing 2 is enclosed to form an accommodating cavity 4, and the enclosed cavity 3 is filled with the phase change material.

Where, the first housing 1 and the second housing 2 refer to complete housings without any separation breakpoint on their surfaces. The first housing 1 is located outside the second housing 2, and completely wraps the second housing 2, and there is a gap between the first housing 1 and the second housing 2 to form the enclosed cavity 3 without any communication with the outside world, and the enclosed cavity 3 is filled with the phase change material. The second housing 2 itself is enclosed to form a cavity without any communication with the outside, and the formed cavity is the accommodating cavity 4 for accommodating the charging unit.

When the temperature-controllable human body charging apparatus with the above structure is implanted into a human body, the first housing 1, as the outermost layer of the temperature-controllable human body charging apparatus, contacts the human body. During the charging process, the charging unit 100 located in the accommodating cavity 4 releases heat, the heat is absorbed by the phase change material located in the enclosed cavity 3 through the second housing 2 and undergoes a gradual phase change. Since the heat is absorbed and intercepted by the phase change material, the heat released by the charging unit 100 may not be conducted to the outside of the charging apparatus through the first housing 1, and thus would not cause the human organ and tissue to be warmed up or even burned.

The present application does not limit the shapes of the first housing 1 and the second housing 2, for example, they can be independently rectangular, triangular, circular, elliptical, or other irregular shapes. In a specific implementation, the first housing 1 is capsule-shaped as shown in FIG. 1. Specifically, the capsule-shaped first housing 1 includes a rectangular housing and an arc-shaped or semi-circular housing located at both ends of the rectangular housing in an extension direction of the rectangular housing. Where, the longest edge of the arc-shaped or semi-circular housing coincides and connects with a circumference of a corresponding end of the rectangular housing, forming the capsule-shaped first housing 1. It should be noted that the capsule-shaped first housing 1 has a more fruity shape to ensure the comfort of the human body.

Furthermore, in order to match the capsule-shaped first housing 1, the second housing 2 is preferably capsule-shaped.

As mentioned above, the phase change material may undergo a phase change at its phase change point to absorb a large amount of heat, and its own temperature may not change after the phase change. In order to further reduce the harm to human body caused by undesirable heat release of the charging apparatus, the present application selects a phase change material with a phase change point not higher than 41°C, and further selects a phase change material with a phase change temperature of 37.5-41°C, and preferably, the phase change point of the phase change material is 38-39°C.

It can be understood that if the temperature of the phase change point is too high, although it helps to absorb more heat, high temperature of the phase change material may cause discomfort to the human body, which is not conducive for the temperature control unit to exert its maximum advantage in the human body.

In a specific implementation, the phase change material includes, for example, at least one of a macromolecular (relative molecular weight greater than 100) fatty hydrocarbon, a macromolecular fatty alcohol, a macromolecular fatty acid, a macromolecular fatty acid ester, a polylactic acid, and an inorganic compound.

Where, the aliphatic hydrocarbon includes at least one of n-nonadecane, n-eicosane, n-heneicosane, n-docosane, n-tricosane and n-tetracosane; the fatty alcohol includes at least one of n-tridecanol, n-tetradecanol, n-pentadecanol and n-hexadecanol; the fatty acid includes at least one of n-decanoic acid, n-undecanoic acid, n-dodecanoic acid, n-tridecanoic acid, n-tetradecanoic acid, n-pentadecanoic acid, n-hexadecanoic acid, n-heptadecanoic acid and n-octadecanoic acid; the fatty acid ester includes at least one of methyl stearate, ethyl stearate, methyl nonadecanoate, ethyl nonadecanoate, methyl eicosanoate and ethyl eicosanoate. When a mixture is selected as the phase change material, the phase change point of the phase change material is related to the choice of compounds in the mixture and a ratio between them. For example, for a mixture of n-eicosane and n-docosane, when a molar ratio of n-eicosane to n-docosane is 0.279:0.721, the phase change temperature of the mixture is 38°C.

The polylactic acid mentioned in the above phase change material is obtained by a preparation method including the following process: heating a raw material mixture system obtained by mixing 6-9g of polylactic acid, 3-5g of tetrakis(4-pyridinyloxymethyl)methane, 2-4g of dodecylbenzenesulfonic acid, 0.3-0.5g of 2,2-bis(4-cyanophenoxymethyl) propane, 0.5-1g of hydrotalcite, 6-9ml of acetic acid, 6-9ml of pyridine, and 1-3ml of methyl ethyl ketone to 120-150°C, stirring for 3-5 hours, cooling, and removing solvent by vacuum distillation of the mixture to obtain a polylactic acid phase change material. During the preparation process, the phase change temperature of the polylactic acid can be controlled at 38-39°C by adjusting a proportion of the raw materials.

The inorganic compound in the above phase change material is obtained by a preparation method including the following process: firstly, mixing 8% by weight (based on a total mass of all raw materials) of sodium formate, 22% by weight of strontium chloride hexahydrate, 10% by weight of water, 8% by weight of maleic anhydride, and 5% by weight of water in sequence to obtain a mixed solution, stirring until uniform, heating for 1 hour, and maintaining the temperature at around 60°C for sufficient reaction; then mixing 9% by weight of sodium chloride, 5% by weight of water, and 2% by weight of potassium persulfate evenly to prepare another mixed solution; afterwards, mixing the above two mixed solutions and adding 26% by weight of calcium chloride hexahydrate, and reacting at 60-70°C under atmospheric pressure for 0.5-1.5 hours to obtain an inorganic polymer material; finally, adding water with a remaining total configuration by weight of 5% to the inorganic polymer material, stirring until uniform, and leaving for 10-15 minutes, to finally obtain an inorganic compound with a phase change point of 38°C.

The phase change material may undergo volume expansion when the phase change material absorbs heat and undergoes phase change, such as during phase change of solid to liquid and phase change of liquid to gas. Therefore, in order to avoid the phenomenon of the phase change material leakages into the body or the accommodating cavity due to deformation and rupture of the housing caused by volume expansion, an original volume of the phase change material is 90%-95% of a volume of the enclosed cavity, that is, a space is reserved for expansion in the enclosed cavity. Where the original volume of the phase change material refers to a volume of the phase change material before it undergoes phase change.

Since the first housing 1 directly contacts human tissue, a material of the first housing 1 is preferably selected from biocompatible materials, such as silica gel, biocompatible metal, etc. In order to further enhance the phase change sensitivity of the phase change material and ensure the normal function of human organ and tissue, the first housing 1 of the present application is further selected as a biocompatible metal material. In the process of wireless charging by the charging unit, the first housing 1 is metal material and is not only conducive to the penetration of alternating electromagnetic field to generate electric energy, but also may increase its own temperature due to the eddy current phenomenon, and at this time both the first housing 1 and the second housing 2 on both sides of the phase change material are in a relatively high temperature state, which is conducive to absorbing heat and phase change of the phase change material. With the progress of charging, a temperature of human organ and tissue on one side of the first housing 1 rises slightly, while a temperature of the phase change material on the other side of the first housing 1 remains unchanged after the phase change has occurred and remains at the phase change temperature. Therefore, a temperature difference between the first housing 1 and human organ and tissue is obviously smaller than that between the first housing 1 and the phase change material. Driven by this temperature difference, the heat generated by the eddy current may tends to flow to the phase change material, so that the heat generated by the eddy current may continue to be conducted to the phase change material. For example, the first housing 1 having biocompatible metal material is a titanium alloy housing or a stainless steel housing, where the titanium alloy housing is more suitable taking electromagnetic penetration and strength into consideration.

Further, since the first housing 1 is in contact with human organ and tissue, human safety should also be taken into consideration when selecting a specific metal material.

The second housing 2 serves as an inner housing, and the material thereof is a nonmetallic polymer (excluding polymers including metal ions). Exemplarily, the nonmetallic polymer includes at least one of polyvinylidene chloride (PVDC), polychlorotrifluoroethylene (PCTFE), polyvinylidene fluoride (PVDF), polytetrafluoroethylene (PTFE), polyester (PET), polypropylene (PP), and the like, and a weight average molecular weight of the nonmetallic polymer is not specifically limited, and further the weight average molecular weight thereof can be greater than or equal to 50,000. On one hand, the nonmetallic polymer material has excellent deformability, which is conducive to buffering the volume expansion during phase change when the phase change material expands. On the other hand, the high stability of the nonmetallic polymer material, which is not easy to be decomposed or degraded, is also conducive to the normal operation of the human body charging apparatus.

Further, a thickness of the first housing 1 is 50-200µm, preferably 50-100 µm; and/or a thickness of the second housing 2 is 100-2000µm, preferably 500-1000 µm. This thickness facilitates the passage of alternating electromagnetic field and reduction of eddy current heat generation effect.

Besides utilizing the temperature control unit to reduce or suppress the adverse effect of the heat generated by the charging unit on human body, the heat generated by the charging unit can also be utilized by a temperature difference power generation unit, which not only further reduces the risk of harm to human body caused by the heat generated by the charging unit, but also provides more electric energy for the active implantable medical device, prolongs the service time of the active implantable medical device and reduces the utilization frequency of the charging unit.

Specifically, the present application does not limit the specific structure of the temperature difference power generation unit. Any functional unit, which is assembled and manufactured based on the Seebeck effect and generates electrical energy utilizing temperature difference, is within the scope of protection of the present application.

FIG. 2 is a structural schematic diagram of a temperature difference power generation unit of a temperature-controllable human body charging apparatus according to an embodiment of the present application. As shown in FIG. 2, a temperature difference power generation unit 300 includes a P-type element 31, an N-type element 32, a first thermal conductor 33, a second thermal conductor 34 and a third thermal conductor 35. Where the P-type element 31 and the N-type element 32 are arranged in parallel, the first thermal conductor 33 is in electrical contact with one end of the P-type element 31 and one end of the N-type element 32, the second thermal conductor 34 is in electrical contact with the other end of the P-type element 31, and the third thermal conductor 35 is in electrical contact with the other end of the N-type element 32. In the application process, the temperature difference power generation unit 300 is electrically connected with the charging unit, and can not only generate electric energy through the temperature difference between the charging unit at high temperature and a non-charging unit at low temperature (an environment except the charging unit), but also transmit the generated electric energy to an energy accumulator in the charging unit for storage.

The specific number of the temperature difference power generation units 300 is not limited in the present application, and it can be greater than or equal to 1. It can be understood that the more the number of temperature difference power generation units 300, the more favorable the conversion of thermal energy to electric energy.

The materials of the P-type element 31 and the N-type element 32 may be an inorganic thermoelectric material, such as at least one of bismuth telluride (BiTe), tin selenide (SnSe), lead telluride ( PbTe), silicon germanium (SiGe), and the like; also may be an organic thermoelectric material, such as at least one of PEDOT:PSS (polyethylene dioxythiophene (polystyrene sulfonic acid doped)), PEDOT:S-PHE (polyethylene dioxythiophene (polystyrene sulfonic acid doped)), PBTTT (thiophene conjugated polymer shown in Formula 1), and the like; also may be an inorganic-organic composite material, such as least one of Te-PEDOT:PSS, SWCNT (single walled carbon nanotube)/PC (polycarbonate)-Te, Te NWs (nanowires)/PEDOT NWs, and the like. When selecting, it is only needed that the material of the P-type element 31 is different from that of the N-type element 32. The first thermal conductor 33, the second thermal conductor 34, and the third thermal conductor 35 can be any material with good electrical and thermal conductivity, such as aluminum, graphite.

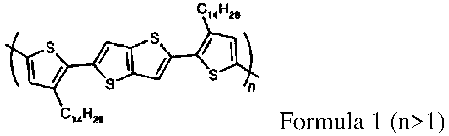

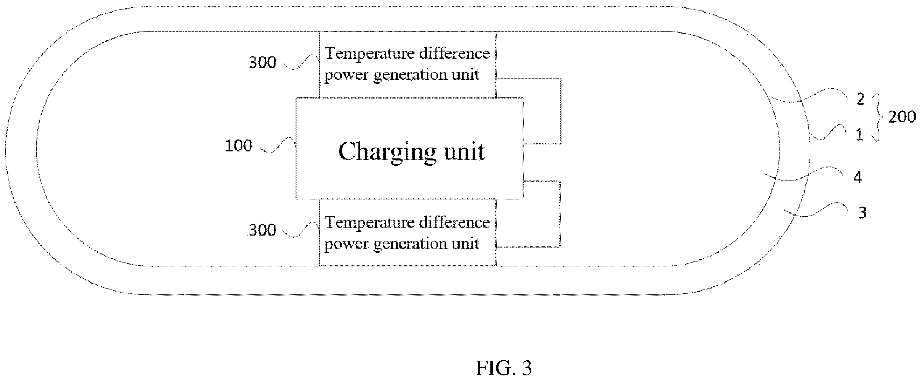

FIG. 3 is a sectional structural schematic diagram of a temperature-controllable human body charging apparatus according to an embodiment of the present application. As shown in FIG. 3, The charging apparatus includes two temperature difference power generation units 300, each of which is located between the second housing 2 and the charging unit 100. Specifically, the first thermal conductor of the temperature difference power generation unit 300 is connected with the charging unit 100 (including direct contact or connecting through thermal conductor), and the second thermal conductor and the third thermal conductor of the temperature difference power generation unit 300 are connected with the second housing 2 (including direct contact or connecting through thermal conductor). Since the temperature of the second housing 2 is lower than that of the charging unit 100, the temperature difference power generation unit 300 utilizes the temperature difference to convert thermal energy into electric energy. By connecting two wires with positive and negative electrodes of the temperature difference power generation unit 300, respectively, and connecting the two wires with positive and negative electrodes of the energy accumulator of the charging unit 100, respectively, storage of electric energy in the charging unit 100 is finally achieved.

### Examples

As shown in FIG. 3, a structure of the temperature-controllable human body charging apparatus of this example includes a charging unit, a temperature control unit and a temperature difference power generation unit.

Where, the temperature control unit includes a capsule-shaped first housing with a first enclosed cavity and a capsule-shaped second housing with a second enclosed cavity, where the second housing is located in the first enclosed cavity of the first housing, a gap between an inner wall of the first housing and an outer wall of the second housing forms an enclosed cavity, and solid-phase n-eicosane, as a phase change material, is filled in the enclosed cavity, and a volume of the solid-phase n-eicosane is 95% of a volume of the enclosed cavity.

The charging unit and the temperature difference power generation unit are accommodated in the second enclosed cavity of the second housing. Where the temperature difference power generation unit includes a bismuth telluride electrode and a tin selenide electrode, which have conductive capability, one end of the bismuth telluride electrode is connected with one end of the tin selenide electrode through a first connecting sheet graphene, and the first connecting sheet graphene is closely fitted with the charging unit; the other end of the bismuth telluride electrode and the other end of the tin selenide electrode are each separately tightly fitted with the second housing through a second connecting sheet graphene and a third connecting sheet graphene, and the second connecting sheet graphene and the third connecting sheet graphene are independent from and not connected with each other. The ends of the bismuth telluride electrode and the tin selenide electrode near the second housing are respectively connected to the energy accumulator (capacitor) of the charging unit to store the electric energy generated by the temperature difference power generation unit.

When wireless charging is carried out, a temperature of the metal conductor part of the charging unit will gradually increase, and it will be transmitted to the second housing and the phase change material n-eicosane between the second housing and the first housing, and the phase change material n-eicosane will start to absorb heat, and a temperature of the phase change material n-eicosane will gradually increase from a body temperature of 37.2°C to 38°C. At this temperature, n-eicosane will begin to undergo a phase change from solid to liquid, absorbing the heat in the housing and the cavity, and keeping the temperature at about 38°C, and thus, the high-rate charging time of wireless charging can be prolonged, and the temperature difference power generation unit can achieve the conversion of thermal energy to electric energy by utilizing the temperature difference between the charging unit and the second housing.

Therefore, by configuring the temperature control unit including the phase change material, the temperature-controllable human body charging apparatus provided by the present application realizes the absorption of heat from the charging unit by the temperature control unit, so as to control the temperature in the patient's body and near the charging apparatus, and avoid the phenomenon that some organs and tissues are burned due to overhigh temperature.

Further, because the temperature control unit overcomes the eddy current and heat generation effect of the charging apparatus, the charging unit has higher tolerance for the related parameters of wireless charging, so that the temperature-controllable human body charging apparatus of the present application can also reduce the cost of the wireless charging apparatus and broaden the application range of the wireless charging apparatus.

## Claims

1. A temperature-controllable in-vivo charging apparatus, comprising a thermally conductive temperature control unit and a charging unit (100), wherein the temperature control unit comprises a phase change material, and the temperature control unit is configured to absorb heat released by the charging unit (100),
**characterized in that** the temperature control unit comprises a housing (200) with an accommodating cavity (4), the charging unit (100) is located in the accommodating cavity (4), and the housing (200) wraps the charging unit (100),
the housing (200) comprises a first housing (1) and a second housing (2), and the first housing (1) is enclosed outside the second housing (2) and forms an enclosed cavity (3) with the second housing (2); the second housing (2) is enclosed to form the accommodating cavity (4), and the enclosed cavity (3) is filled with the phase change material, and
the temperature-controllable in-vivo charging apparatus further comprises N temperature difference power generation units (300), wherein each temperature difference power generation unit (300) is electrically connected with the charging unit (100), N≥1; and each temperature difference power generation unit (300) is located between the second housing (2) and the charging unit (100).

2. The temperature-controllable in-vivo charging apparatus according to claim 1, wherein the first housing (1) is capsule-shaped.

3. The temperature-controllable in-vivo charging apparatus according to claim 1 or 2, wherein the second housing (2) is capsule-shaped.

4. The temperature-controllable in-vivo charging apparatus according to any one of claims 1-3, wherein a phase change temperature of the phase change material is not higher than 41°C,
and/or the phase change temperature of the phase change material is 37.5-41°C,
and/or the phase change temperature of the phase change material is 38-39°C.

5. The temperature-controllable in-vivo charging apparatus according to claim 4, wherein the phase change material comprises at least one of macromolecular aliphatic hydrocarbon, macromolecular fatty alcohol, macromolecular fatty acid, macromolecular fatty acid ester, polylactic acid and inorganic compound.

6. The temperature-controllable in-vivo charging apparatus according to claim 4 or 5, wherein the phase change material comprises n-eicosane and n-docosane.

7. The temperature-controllable in-vivo charging apparatus according to claim 6, wherein a molar ratio of the n-eicosane to the n-docosane is 0.279:0.721.

8. The temperature-controllable in-vivo charging apparatus according to any one of claims 1-3, wherein an original volume of the phase change material is 90%-95% of a volume of the enclosed cavity (3).

9. The temperature-controllable in-vivo charging apparatus according to any one of claims 1, 2, 3 or 8, wherein a material of the first housing (1) is a metal material; and/or
wherein a material of the second housing (2) is a nonmetallic polymer.

10. The temperature-controllable in-vivo charging apparatus according to claim 9, wherein a thickness of the first housing (1) is 50-200 µm; and/or
the thickness of the first housing (1) is 50-100 µm.

11. The temperature-controllable in-vivo charging apparatus according to claim 9 or 10, wherein a thickness of the second housing (2) is 100-2000 µm; and/or
the thickness of the second housing (2) is 500-1000 µm.

12. The temperature-controllable in-vivo charging apparatus according to any one of claims 1-11, wherein the charging unit (100) comprises a wireless receiving coil, a rectifier, an energy accumulator and a controller, which are electrically connected in sequence.

## Patentansprüche

1. In-vivo-Aufladevorrichtung mit steuerbarer Temperatur, umfassend eine wärmeleitfähige Temperatursteuereinheit und eine Ladeeinheit (100), wobei die Temperatursteuereinheit ein Phasenwechselmaterial umfasst und die Temperatursteuereinheit konfiguriert ist, um von der Ladeeinheit (100) abgegebene Wärme zu absorbieren,
**dadurch gekennzeichnet, dass** die Temperatursteuereinheit ein Gehäuse (200) mit einem Aufnahmehohlraum (4) umfasst, die Ladeeinheit (100) in dem Aufnahmehohlraum (4) angeordnet ist und das Gehäuse (200) die Ladeeinheit (100) umschließt,
das Gehäuse (200) ein erstes Gehäuse (1) und ein zweites Gehäuse (2) umfasst und das erste Gehäuse (1) das zweite Gehäuse (2) außenseitig umschließt und mit dem zweiten Gehäuse (2) einen umschlossenen Hohlraum (3) bildet; das zweite Gehäuse (2) den Aufnahmehohlraum (4) umschließt und der umschlossene Hohlraum (3) mit dem Phasenwechselmaterial gefüllt ist, und
die In-vivo-Aufladevorrichtung mit steuerbarer Temperatur ferner N Temperaturdifferenz-Stromerzeugungseinheiten (300) umfasst, wobei jede Temperaturdifferenz-Stromerzeugungseinheit (300) elektrisch mit der Ladeeinheit (100) verbunden ist, N ≥ 1; und jede Temperaturdifferenz-Stromerzeugungseinheit (300) zwischen dem zweiten Gehäuse (2) und der Ladeeinheit (100) angeordnet ist.

2. In-vivo-Aufladevorrichtung mit steuerbarer Temperatur nach Anspruch 1, wobei das erste Gehäuse (1) kapselförmig ist.

3. In-vivo-Aufladevorrichtung mit steuerbarer Temperatur nach Anspruch 1 oder 2, wobei das zweite Gehäuse (2) kapselförmig ist.

4. In-vivo-Aufladevorrichtung mit steuerbarer Temperatur nach einem der Ansprüche 1 bis 3, wobei eine Phasenwechseltemperatur des Phasenwechselmaterials nicht höher als 41 °C ist,
und/oder die Phasenwechseltemperatur des Phasenwechselmaterials 37,5-41 °C beträgt
und/oder die Phasenwechseltemperatur des Phasenwechselmaterials 38-39 °C beträgt.

5. In-vivo-Aufladevorrichtung mit steuerbarer Temperatur nach Anspruch 4, wobei das Phasenwechselmaterial mindestens eines von makromolekularem aliphatischem Kohlenwasserstoff, makromolekularem Fettalkohol, makromolekularer Fettsäure, makromolekularem Fettsäureester, Polymilchsäure und anorganischer Verbindung umfasst.

6. In-vivo-Aufladevorrichtung mit steuerbarer Temperatur nach Anspruch 4 oder 5, wobei das Phasenwechselmaterial n-Eicosan und n-Docosan umfasst.

7. In-vivo-Aufladevorrichtung mit steuerbarer Temperatur nach Anspruch 6, wobei ein Molverhältnis des n-Eicosans zu dem n-Docosan 0,279:0,721 beträgt.

8. In-vivo-Aufladevorrichtung mit steuerbarer Temperatur nach einem der Ansprüche 1 bis 3, wobei ein Ausgangsvolumen des Phasenwechselmaterials 90-95 % eines Volumens des umschlossenen Hohlraums (3) beträgt.

9. In-vivo-Aufladevorrichtung mit steuerbarer Temperatur nach einem der Ansprüche 1, 2, 3 oder 8, wobei ein Material des ersten Gehäuses (1) ein metallisches Material ist; und/oder
wobei ein Material des zweiten Gehäuses (2) ein nichtmetallisches Polymer ist.

10. In-vivo-Aufladevorrichtung mit steuerbarer Temperatur nach Anspruch 9, wobei eine Dicke des ersten Gehäuses (1) 50-200 µm beträgt; und/oder
die Dicke des ersten Gehäuses (1) 50-100 µm beträgt.

11. In-vivo-Aufladevorrichtung mit steuerbarer Temperatur nach Anspruch 9 oder 10, wobei eine Dicke des zweiten Gehäuses (2) 100-2000 µm beträgt; und/oder
die Dicke des zweiten Gehäuses (2) 500-1000 µm beträgt.

12. In-vivo-Aufladevorrichtung mit steuerbarer Temperatur nach einem der Ansprüche 1 bis 11, wobei die Ladeeinheit (100) eine drahtlose Empfangsspule, einen Gleichrichter, einen Energiespeicher und eine Steuereinheit umfasst, die elektrisch nacheinander verbunden sind.

## Revendications

1. Un appareil de charge in vivo à température réglable, comprenant une unité de commande de température thermiquement conductrice et une unité (100) de charge, dans lequel l'unité de commande de température comprend un matériau à changement de phase, et l'unité de commande de température est configurée pour absorber la chaleur libérée par l'unité (100) de charge,
**caractérisé en ce que** l'unité de commande de température comprend un boîtier (200) avec une cavité (4) de réception, l'unité (100) de charge est située dans la cavité de réception (4), et le boîtier (200) enveloppe l'unité (100) de charge,
le boîtier (200) comprend un premier boîtier (1) et un second boîtier (2), et le premier boîtier (1) est enfermé à l'extérieur du second boîtier (2) et forme une cavité (3) fermée avec le second boîtier (2) ; le second boîtier (2) est enfermé pour former la cavité (4) de réception, et la cavité (3) fermée est remplie du matériau à changement de phase, et
l'appareil de charge in vivo à température réglable comprend en outre N unités (300) de génération d'énergie à différence de température, chaque unité (300) de génération d'énergie à différence de température étant électriquement connectée à l'unité (100) de charge, N ≥ 1 ; et chaque unité (300) de génération d'énergie à différence de température étant située entre le second boîtier (2) et l'unité (100) de charge.

2. L'Appareil de charge in vivo à température réglable selon la revendication 1, dans lequel le premier boîtier (1) est en forme de capsule.

3. L'Appareil de charge in vivo à température réglable selon la revendication 1 ou 2, dans lequel le second boîtier (2) est en forme de capsule.

4. L'Appareil de charge in vivo à température réglable selon l'une quelconque des revendications 1 à 3, dans lequel une température de changement de phase du matériau à changement de phase n'est pas supérieure à 41 °C,
et/ou la température de changement de phase du matériau à changement de phase est comprise entre 37,5 et 41 °C
et/ou la température de changement de phase du matériau à changement de phase est comprise entre 38 et 39 °C.

5. L'Appareil de charge in vivo à température réglable selon la revendication 4, dans lequel le matériau à changement de phase comprend au moins un hydrocarbure aliphatique macromoléculaire, un alcool gras macromoléculaire, un acide gras macromoléculaire, un ester d'acide gras macromoléculaire, un acide polylactique et un composé inorganique.

6. L'Appareil de charge in vivo à température réglable selon la revendication 4 ou 5, dans lequel le matériau à changement de phase comprend du n-eicosane et du n-docosane.

7. L'Appareil de charge in vivo à température réglable selon la revendication 6, dans lequel un rapport molaire du n-eicosane au n-docosane est de 0,279:0,721.

8. L'Appareil de charge in vivo à température réglable selon l'une quelconque des revendications 1 à 3, dans lequel un volume d'origine du matériau à changement de phase est compris entre 90 % et 95 % d'un volume de la cavité (3) fermée.

9. L'Appareil de charge in vivo à température réglable selon l'une quelconque des revendications 1, 2, 3 ou 8, dans lequel un matériau du premier boîtier (1) est un matériau métallique ; et/ou
dans lequel un matériau du second boîtier (2) est un polymère non métallique.

10. L'Appareil de charge in vivo à température réglable selon la revendication 9, dans lequel une épaisseur du premier boîtier (1) est comprise entre 50 et 200 µm ; et/ou
l'épaisseur du premier boîtier (1) est comprise entre 50 et 100 µm.

11. L'Appareil de charge in vivo à température réglable selon la revendication 9 ou 10, dans lequel une épaisseur du second boîtier (2) est comprise entre 100 et 2000 µm ; et/ou
l'épaisseur du deuxième boîtier (2) est comprise entre 500 et 1000 µm.

12. L'Appareil de charge in vivo à température réglable selon l'une quelconque des revendications 1 à 11, dans lequel l'unité (100) de charge comprend une bobine de réception sans fil, un redresseur, un accumulateur d'énergie et un dispositif de commande, qui sont connectés électriquement en séquence.
